# FASCICULE DE BREVET EUROPEEN

(11) **EP 2 939 275 B1**
(45) Date de publication et mention de la délivrance du brevet: **19.10.2016**
(21) Numéro de dépôt: 13814991.9
(22) Date de dépôt: 27.12.2013
(51) Int. Cl.: H01L 31/107, H01L 31/18

(54) **STRUCTURE SEMICONDUCTRICE DU TYPE PHOTODIODE À AVALANCHE À HAUT RAPPORT SIGNAL SUR BRUIT ET PROCÉDÉ DE FABRICATION D'UNE TELLE PHOTODIODE**
HALBLEITERSTRUKTUR MIT LAWINENPHOTODIODE MIT HOHEM RAUSCHABSTAND UND VERFAHREN ZUR HERSTELLUNG SOLCH EINER PHOTODIODE
AVALANCHE PHOTODIODE SEMICONDUCTOR STRUCTURE HAVING A HIGH SIGNAL-TO-NOISE RATIO AND METHOD FOR MANUFACTURING SUCH A PHOTODIODE

(30) Priorité: 31.12.2012 FR 1262991
(43) Date de publication de la demande: 04.11.2015
(73) Titulaire: Commissariat à l'Énergie Atomique et aux Énergies Alternatives, 75015 Paris (FR)
(72) Inventeur: ROTHMAN, Johan, F-38000 Grenoble (FR)
(74) Mandataire: Brevalex
(86) Numéro de dépôt international: PCT/EP2013/078088
(87) Numéro de publication internationale: WO 2014/102353

(56) Documents cités:
- EP-A2- 0 325 532
- CA-C- 1 298 640
- US-B1- 6 747 296
- ANAND SINGH ET AL: "HgCdTe avalanche photodiodes: A review", OPTICS AND LASER TECHNOLOGY, ELSEVIER SCIENCE PUBLISHERS BV., AMSTERDAM, NL, vol. 43, no. 7, 7 mars 2011 (2011-03-07), pages 1358-1370, XP028384723, ISSN: 0030-3992, DOI: 10.1016/J.OPTLASTEC.2011.03.009 [extrait le 2011-03-10]
- WANG S ET AL: "Low-noise avalanche photodiodes with graded impact-ionization-engineered multiplication region", IEEE PHOTONICS TECHNOLOGY LETTERS, IEEE SERVICE CENTER, PISCATAWAY, NJ, US, vol. 13, no. 12, 1 décembre 2001 (2001-12-01), pages 1346-1348, XP011426604, ISSN: 1041-1135, DOI: 10.1109/68.969903

## Description

### DOMAINE TECHNIQUE

L'invention se rapporte au domaine des dispositifs de mesure et de détection de lumière.

Ces dernières années, l'application des méthodes de fabrication de la micro-électronique à des matériaux semiconducteurs à gap direct ont permis d'améliorer les performances des structures optoélectroniques.

Parmi ces structures optoélectroniques, les photodiodes à avalanche présentent une sensibilité améliorée avec une forte baisse du courant d'obscurité. Néanmoins, malgré l'amélioration de cette sensibilité, la détection de photons uniques à température ambiante reste encore difficile avec de telles structures.

Ainsi, l'amélioration de la sensibilité des photodiodes à avalanche reste une problématique actuelle.

L'invention se rapporte donc plus particulièrement à une structure semiconductrice de type photodiode à avalanche à haut rapport signal sur bruit et à un procédé de fabrication d'une telle structure.

### ÉTAT DE LA TECHNIQUE ANTÉRIEURE

Ces dernières années, différentes pistes de recherche ont été explorées afin d'améliorer les structures du type photodiode à avalanche, ceci dans le but d'améliorer les possibilités de détection de photons uniques à température ambiante.

Un pas important vers de telles structures a été réalisé avec l'arrivée de matériaux, tels que les tellurures de mercure-cadmium, permettant d'obtenir une multiplication de porteurs par ionisation par impact prépondérante pour un seul type de porteurs.

En effet, de tels matériaux permettent d'éviter, comme l'ont notamment démontré les travaux J. Rothman et ses collaborateurs publiés en 2011 dans le Journal of Electronic Material, N° 40, page 1757, une interaction parasite entre les deux types de porteurs circulant dans la zone de multiplication. Il en résulte une réduction importante du bruit généré dans cette zone et un temps de réponse amélioré.

Une structure comportant un tel matériau dans la zone destinée à la multiplication de porteurs comporte généralement :
- une première zone semiconductrice d'un premier type de conductivité présentant une première face destinée à recevoir le rayonnement électromagnétique et une seconde face opposée à la première face, le matériau semiconducteur dans lequel est formée ladite première zone présentant une largeur de bande interdite adaptée pour favoriser l'absorption du rayonnement électromagnétique,
- une deuxième zone semiconductrice en contact avec la seconde face de la première zone, la deuxième zone présentant une concentration en porteurs majoritaires inférieure à celle de la première zone, ladite deuxième zone étant adaptée pour fournir une multiplication de porteurs par ionisation par impact qui est prépondérante pour un type de porteurs,
- une troisième zone semiconductrice en contact avec la deuxième zone semiconductrice, ladite troisième zone étant d'un deuxième type de conductivité opposé au premier type de conductivité et présentant une concentration en porteurs majoritaires supérieure à celle de la deuxième zone semiconductrice.

Néanmoins, si ce type de structure présente une sensibilité améliorée vis-à-vis d'une structure du type photodiode à avalanche ne comportant pas de deuxième zone adaptée pour fournir une multiplication de porteurs par ionisation par impact qui est prépondérante pour un type de porteurs, la sensibilité d'une telle structure n'est pas encore suffisante pour certaines applications, telles que la détection de photons uniques à température ambiante.

### EXPOSÉ DE L'INVENTION

La présente invention vise à remédier à ces inconvénients.

L'invention a donc pour but de fournir une photodiode à avalanche qui possède un rapport signal sur bruit augmenté vis-à-vis d'une structure selon l'art antérieur qui présente un gain de multiplication de porteurs identique.

A cet effet, l'invention concerne une structure semiconductrice de type photodiode à avalanche telle que définie dans la revendication 1.

On entend par le fait que la deuxième sous-partie relie la première sous-partie à la troisième zone, soit que la deuxième sous-partie relie directement la première sous-partie à la troisième zone et donc que la deuxième sous-partie fait interface entre la première sous-partie et la troisième zone, soit que la deuxième sous-partie relie avec une autre partie de la deuxième zone, telle qu'une mineure partie de la deuxième zone, la première sous-partie avec la troisième zone.

On entend par taux moyen de multiplication de porteurs par micromètre d'une partie de la deuxième zone, le nombre moyen de porteurs générés par ionisation par impact dans ladite partie de la deuxième zone par un porteur lors de son transit dans ladite partie de la deuxième zone divisé par la distance de parcours moyenne parcourue par un porteur transitant dans cette même partie de la deuxième zone ceci lors du fonctionnement de la structure. Bien entendu, la structure est considérée en fonctionnement lorsqu'elle est soumise à une polarisation nominale de fonctionnement, telle qu'une polarisation de 12V.

On entend par « multiplication de porteurs par ionisation par impact qui est prépondérante pour un type de porteur » que la multiplication par impact de l'un des types de porteurs est négligeable vis-à-vis de la multiplication par impact de l'autre type de porteurs, c'est à dire que le rapport entre les deux taux de multiplication est supérieur à 50, préférentiellement 100, voire 1000. Ainsi, une telle prépondérance peut aller jusqu'à une suppression de l'ionisation par impacte de l'autre type de porteurs, la multiplication par impact n'ayant lieu que pour un type de porteurs et non pour le deuxième type de porteurs.

Ainsi, les porteurs générés dans la première zone, lors de leur transit vers la troisième zone, traversent tour à tour la première sous-partie et la deuxième sous-partie. La première sous-partie, en présentant un taux moyen de multiplication de porteurs par micromètre réduit, permet d'augmenter le courant de porteurs avec une réduction du rapport signal sur bruit qui reste contenue. Le courant de porteurs est ainsi faiblement augmenté avec un rapport signal sur bruit qui reste important. Le courant de porteurs transite ensuite par la deuxième sous-partie dans laquelle il est significativement augmenté par le fort taux moyen de multiplication de porteurs par micromètre que présente la deuxième sous-partie.

La deuxième zone peut présenter une concentration en porteurs majoritaires au moins inférieure de 10 fois celle de la première zone.

La troisième zone peut présenter une concentration en porteurs majoritaires au moins 10 fois plus importante que celle de la deuxième zone semiconductrice.

Le bruit généré dans cette deuxième sous-partie, s'il est significativement important vis-à-vis de celui généré dans la première sous-partie, reste réduit par rapport au courant de porteurs après qu'il ait été augmenté par son passage dans la première sous-partie. Ainsi, la structure présente un gain de multiplication du courant de porteurs important, qui est de l'ordre de grandeur de celui généré par la deuxième sous-partie, avec une réduction du rapport signal sur bruit qui reste contenue et ce dernier qui est de l'ordre du rapport signal sur bruit en sortie de la première sous-partie. Une telle structure présente donc une sensibilité améliorée vis-à-vis d'une structure selon l'art antérieur qui présente une deuxième zone adaptée pour fournir une multiplication de porteurs par ionisation par impact qui est prépondérante pour un type de porteur, la multiplication de l'autre type de porteurs étant négligeable.

On entend ci-dessus par gain de multiplication de porteurs dans une partie ou une zone donnée, le nombre moyen de porteurs générés par ionisation par impact dans ladite partie ou zone lors du transit d'un porteur dans cette même partie ou zone.

De façon alternative, l'invention peut également concerner une structure semiconductrice de type photodiode à avalanche destinée à recevoir un rayonnement électromagnétique dans une gamme de longueurs d'onde donnée et comportant :
- une première zone semiconductrice, dite d'absorption, d'un premier type de conductivité présentant une première face destinée à recevoir le rayonnement électromagnétique et une seconde face opposée à la première face, le matériau semiconducteur dans lequel est formée ladite première zone présentant une largeur de bande interdite adaptée pour favoriser l'absorption du rayonnement électromagnétique,
- une deuxième zone semiconductrice, dite de multiplication, en contact avec la seconde face de la première zone, la deuxième zone présentant une concentration en porteurs majoritaires inférieure à celle de la première zone, ladite deuxième zone étant adaptée pour fournir une multiplication de porteurs par ionisation par impact qui est prépondérante pour un type de porteurs,
- une troisième zone semiconductrice, dite de collecte, en contact avec la deuxième zone semiconductrice, ladite troisième zone étant d'un deuxième type de conductivité opposé au premier type de conductivité et présentant une concentration en porteurs majoritaires supérieure à celle de la deuxième zone semiconductrice,

la deuxième zone comporte au moins deux sous-parties, une première sous-partie par laquelle la deuxième zone est en contact avec la première zone et une deuxième sous-partie reliant la première sous-partie à la troisième zone, la deuxième sous-partie étant adaptée pour présenter un taux de multiplication de porteurs supérieur à celui de la première sous-partie, et préférentiellement supérieur à 3 fois, 5 fois, voire 10 fois le taux de multiplication de porteurs de la première sous-partie, la première et la deuxième sous-partie présentant des épaisseurs du même ordre de grandeur.

On entend ci-dessus et dans le reste de ce document par taux de multiplication de porteurs par une partie de la deuxième zone, le nombre moyen de porteurs générés par ionisation par impact dans ladite partie de la deuxième zone par un porteur lors de son transit dans ladite partie de la deuxième zone ceci en fonctionnement de la structure.

On peut noter que, pour une première et une deuxième sous-couche présentant des épaisseurs du même ordre de grandeur, le rapport de taux moyen de multiplication de porteurs par micromètre entre la première et la deuxième sous-couche présente une valeur similaire à celle du rapport de taux de multiplication de porteurs entre ces mêmes première et deuxième sous-parties.

Les première, deuxième et troisième zones (210, 310, 410) peuvent toutes trois être réalisées dans des tellurures de mercure-cadmium du type CdₓHg₁₋ₓTe avec des proportions x en cadmium différentes les une des autres, le premier type de conductivité étant un type de conductivité dans lequel les porteurs majoritaires sont des trous, assurant de cette manière que l'ionisation par impact dans la deuxième zone est prépondérante pour les électrons.

La deuxième sous-partie peut être réalisée dans un matériau semiconducteur présentant une largeur de bande interdite inférieure à celle du matériau semiconducteur dans lequel est formée la première sous-partie de manière à présenter le taux moyen de multiplication de porteurs par micromètre supérieur à celui de la première sous-partie.

Une telle variation de la largeur de bande interdite entre la première et la seconde sous-partie de la deuxième zone permet de fournir une première et une deuxième sous-partie avec des taux moyens de multiplication de porteurs par micromètre différents l'une de l'autre.

La première et la deuxième sous-partie sont réalisées dans des tellurures de mercure-cadmium du type CdₓHg₁₋ₓTe avec des proportions x en cadmium différentes l'une de l'autre.

Une première et une deuxième sous-partie réalisées dans des tellurures de mercure-cadmium permettent de fournir une deuxième zone qui présente une multiplication de porteurs par ionisation par impact qui est prépondérante pour les électrons avec la deuxième sous-partie qui présente une largeur de bande interdite inférieure à celle de la première sous-partie. De plus, l'interface entre la première et la deuxième sous-partie est sensiblement exempte de défauts cristallins et ne génère donc par un courant d'obscurité significatif. En effet les tellurures de mercure-cadmium possèdent, entre autre avantage, de présenter une variation importante de la largeur de bande interdite en variant la proportion de cadmium sans variation significative des paramètres de maille cristallins.

La première et la deuxième sous-partie de la première zone peuvent présenter le deuxième type de conductivité.

La première sous-partie peut présenter le premier type de conductivité, la deuxième sous-partie présentant le deuxième type de conductivité.

La première et la deuxième sous-partie peuvent présenter le premier type de conductivité.

Les taux moyens de multiplication de porteurs par micromètre différents pour la première et la deuxième sous-partie dans une telle structure sont ainsi obtenus sans qu'il soit nécessaire d'utiliser des matériaux différents pour former les deux sous-parties, ce qui limite les risques d'apparition de défauts cristallin à l'interface de ces deux sous-parties. En effet, ce type de défauts est généralement lié à une interface entre deux matériaux présentant une différence importante de mailles cristallines.

La première sous-partie peut présenter un gain de multiplication de porteurs compris entre 2 et 10, la deuxième sous-partie présentant un gain de multiplication de porteurs compris entre 10 et 500.

La structure peut en outre être destinée à recevoir un rayonnement électromagnétique dans une deuxième gamme de longueurs d'onde d'énergies inférieures à celles de la première gamme de longueurs d'onde, la deuxième sous-partie de la deuxième zone comportant une largeur de bande interdite inférieure à celle de la première zone semiconductrice et à celle de la première sous-partie et qui est adaptée pour favoriser l'absorption du rayonnement électromagnétique dans la deuxième gamme de longueurs d'onde.

Une telle structure permet de détecter et mesurer de façon efficace un rayonnement électromagnétique dont la longueur d'onde est comprise dans la gamme de longueurs d'onde donnée, les porteurs générés par un tel rayonnement étant multipliés dans la deuxième zone. Elle permet également de détecter et de mesurer un rayonnement électromagnétique dont la longueur d'onde est comprise dans la deuxième gamme de longueurs d'onde.

La première et la deuxième sous-partie de la première zone sont toutes deux des couches dont l'épaisseur minimum est supérieure à 200 nm.

De tells épaisseurs permettent d'assurer un gain significatif pour chacune de ces sous-parties de la deuxième zone. En effet, 200 nm étant, pour les tellurures de mercure-cadmium, la distance de libre parcours moyen entre 2 ionisations, chaque porteur entrant dans l'une de la première et de la deuxième sous partie de la deuxième zone devrait générer au moins une ionisation par impact, permettant ainsi d'obtenir un gain significatif.

L'invention concerne également un procédé de fabrication d'une structure semiconductrice selon l'une quelconque des revendications précédentes comportant les étapes consistant à :
- fournir une première zone semiconductrice d'un premier type de conductivité présentant une première face destinée à recevoir le rayonnement électromagnétique et une seconde face opposée à la première face, le matériau semiconducteur dans lequel est formée ladite première zone présentant une largeur de bande interdite adaptée pour favoriser l'absorption du rayonnement électromagnétique,
- former une deuxième zone semiconductrice en contact avec la seconde face de la première zone, la deuxième zone présentant une concentration en porteurs majoritaires inférieure à celle de la première zone, ladite deuxième zone étant adaptée pour fournir une multiplication de porteurs par ionisation par impact qui est prépondérante pour un type de porteurs, la deuxième zone comportant au moins deux sous-parties, une première sous-partie par laquelle la deuxième zone est en contact avec la première zone et une deuxième sous-partie destinée à relier la première sous-partie à la troisième zone, la deuxième sous-partie étant adaptée pour présenter un taux moyen de multiplication de porteurs par micromètre supérieur au taux moyen de multiplication de porteurs par micromètre de la première sous-partie, et préférentiellement supérieur à 3 fois, 5 fois, voire 10 fois le taux moyen de multiplication de porteurs par micromètre de la première sous-partie.
- former une troisième zone semiconductrice en contact avec la deuxième zone semiconductrice, ladite troisième zone étant d'un deuxième type de conductivité opposé au premier type de conductivité et présentant une concentration en porteurs majoritaires supérieure à celle de la deuxième zone semiconductrice.

Un tel procédé permet de fournir une structure qui présente donc une sensibilité améliorée vis-à-vis d'une structure selon l'art antérieur comportant une deuxième zone adaptée pour fournir une multiplication de porteurs par ionisation par impact qui est prépondérante pour un type de porteur.

La deuxième zone pouvant être formée en un tellurure mercure-cadmium du type CdₓHg₁₋ₓTe, l'étape de formation de la deuxième zone peut comporter une sous-étape de formation de la première sous-partie dans un tellurure de mercure-cadmium avec une première proportion x₁ en cadmium et une sous-étape de formation de la deuxième sous-partie dans un tellurure de mercure-cadmium avec une deuxième proportion x₂ en cadmium qui est inférieure à la première proportion x₁ en cadmium.

De telles sous étapes permettent de fournir une structure avec une deuxième zone qui, tout en présentant une multiplication de porteurs par ionisation par impact qui est prépondérante pour les électrons avec la deuxième sous-partie qui présente une largeur de bande interdite supérieure à celle de la première sous-partie, comporte une interface entre la première et la deuxième sous-partie sensiblement exempte de défauts cristallins. En effet les tellurures de mercure-cadmium permettent une variation importante de la largeur de bande interdite en variant la proportion de cadmium sans variation significative des paramètres de maille cristallins.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre une vue en coupe d'une structure selon un premier mode réalisation de l'invention,
- la figure 2 illustre graphiquement la variation du taux de multiplication d'une zone de multiplication en tellurure de mercure-cadmium d'une structure de l'art antérieur ceci en fonction à la fois de la tension de polarisation de la structure et de la fréquence de coupure de la deuxième couche semiconductrice, cette figure est extraite de l'article de J. Rothman et Al. publié dans la revue scientifique « Journal of Electronic Materials » n°42 p2928 en 2012,
- la figure 3 illustre une vue en coupe d'une structure selon un deuxième mode de réalisation de l'invention dans lequel la structure comporte une troisième zone semiconductrice qui s'étend sur la totalité de la largeur de la deuxième zone semiconductrice,
- la figure 4 illustre une vue en coupe d'une structure selon un troisième mode de réalisation de l'invention dans lequel la structure comporte une couche d'adaptation,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

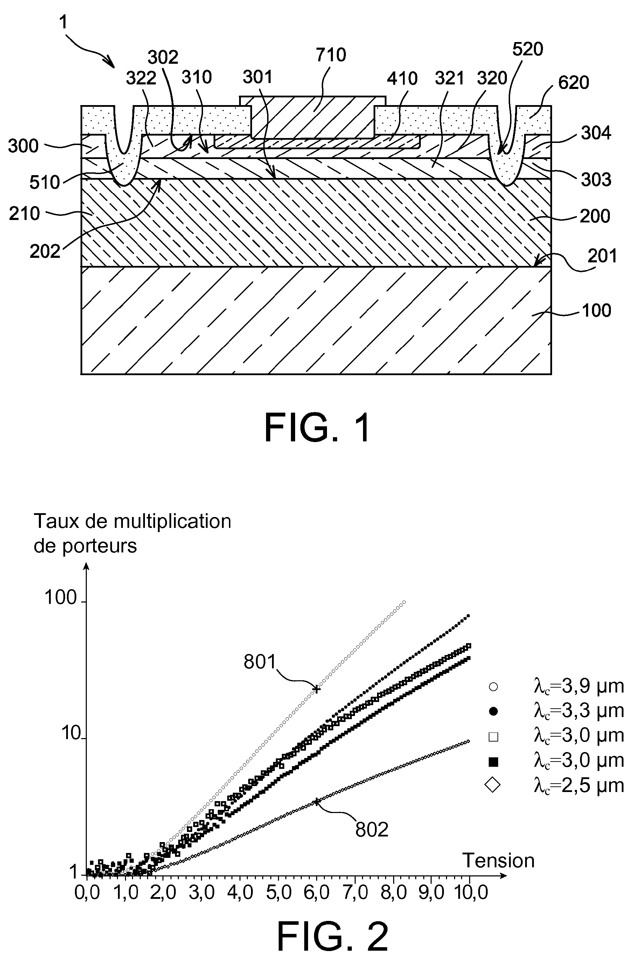

La figure 1 illustre une structure 1 semiconductrice selon un premier mode de réalisation, ladite structure 1 étant destinée à la détection et la mesure d'un rayonnement électromagnétique dont la longueur d'onde est comprise dans une gamme de longueurs d'onde donnée.

Afin d'illustrer et de faciliter la compréhension du fonctionnement de la structure selon l'invention, les valeurs et les matériaux qui sont cités ci-dessous, quand cela est précisé, concernent une application particulière de l'invention à la détection et à la mesure de rayonnements électromagnétiques dont la longueur d'onde est comprise dans la gamme de longueurs d'onde du proche infrarouge. Bien entendu, les valeurs et les matériaux concernant cette application ne sont donnés qu'à titre d'illustration et ne sont pas limitatifs.

On entend ci-dessus et dans le reste de ce document par gamme de longueurs d'onde du proche infrarouge une gamme de longueurs d'onde comprise entre 0,8 µm et 3 µm.

Une structure 1 selon le premier mode de réalisation de l'invention comporte :
- un support 100,
- une première zone 210 semiconductrice d'un premier type de conductivité présentant une première face 201 destinée à recevoir le rayonnement électromagnétique et une seconde face 202 opposée à la première face 201, ladite première zone 210 comportant une largeur de bande interdite adaptée pour favoriser l'absorption du rayonnement électromagnétique,
- une deuxième zone 310 semiconductrice en contact par une première face 301 longitudinale avec la seconde face 202 de la première zone 210, la deuxième zone 310 comportant une première et une deuxième sous-partie 321, 322, la deuxième zone 310 étant en contact avec la première zone 210 par sa première sous-partie 321,
- une troisième zone 410 semiconductrice en contact avec la deuxième sous-partie 322 de la deuxième zone 310 semiconductrice, ladite troisième zone 410 étant d'un deuxième type de conductivité opposé au premier type de conductivité,
- une cavité 520 entourant la deuxième zone 310,
- un contact électrique 710 en contact avec la troisième zone 410 et adapté pour polariser la troisième zone 410, le contact électrique formant un premier moyen de polarisation,
- un deuxième moyen de polarisation, non illustré, adapté pour polariser la première zone 210,
- une couche de passivation 620 en contact avec la deuxième et la troisième zone 310, 410.

Le support 100 est un support adapté pour la formation de la première zone 210 et est au moins partiellement transparent dans la gamme de longueurs d'onde donnée. Ainsi le support 100 peut être réalisé dans un matériau isolant ou semiconducteur dont la largeur de bande interdite est adaptée pour être supérieure à l'énergie des photons d'un rayonnement électromagnétique dont la longueur d'onde est dans la gamme de longueurs d'onde donnée.

Dans l'application particulière le support 100 peut être réalisé en tellurure de zinc-cadmium CdZnTe. En effet, le matériau tellurure de zinc-cadmium CdZnTe présente une énergie de bande interdite d'au moins 1,4 eV, et est donc transparent aux infrarouges et peu sensible au bruit thermique.

Le support 100 présente une première et une seconde face, la première face étant la face qui est destinée à recevoir le rayonnement électromagnétique.

La structure 1 comporte en outre une première couche 200 semiconductrice en contact avec le support. La première couche 200 est réalisée dans un matériau semiconducteur dont la largeur de bande interdite est adaptée pour autoriser l'absorption des rayonnements électromagnétiques dont la longueur d'onde est comprise dans la gamme de longueurs d'onde donnée. Ainsi la première couche 200 est réalisée dans un matériau semiconducteur dont la largeur de bande interdite est inférieure à l'énergie des photons d'un rayonnement électromagnétique dont la longueur d'onde est comprise dans la gamme de longueurs d'onde donnée.

La première couche 200 est d'un premier type de conductivité. Le premier type de conductivité est choisi parmi le type de conductivité pour lequel les porteurs majoritaires sont des électrons et le type de conductivité pour lequel les porteurs majoritaires sont des trous.

L'épaisseur de la première couche 200 est adaptée pour qu'une majeure partie d'un rayonnement reçu par la première face de la structure 1 au niveau de la première zone 210 soit absorbée par la première zone 210.

Dans l'application particulière, la première couche 200 est formée dans un tellurure de mercure-cadmium CdₓHg₁₋ₓTe dont la proportion en cadmium x est comprise entre 0,33 et 0,6. Avec une proportion de cadmium de 0,33 et 0,6, la première couche est adaptée pour absorber à une température de 300 K un rayonnement électromagnétique dans une gamme de longueur d'onde respectivement inférieure à 3,7 µm et à 1,8 µm.

Dans cette même application particulière, le premier type de conductivité est du type de conductivité pour lequel les porteurs majoritaires sont des trous. La concentration en porteurs majoritaires dans la première couche 200 est préférentiellement comprise entre 10¹⁶ et 10¹⁷ cm⁻³. Selon cette application, la première couche 210 présente une épaisseur comprise entre 0,5 et 2 µm.

Selon cette même application particulière, la première couche, afin d'obtenir le premier type de conductivité, comporte des éléments dopants, tels que l'arsenic As, l'or Au ou encore l'antimoine Sb, adaptés pour donner au moins un porteur correspondant au premier type de conductivité lorsqu'ils sont activés.

La partie de la première couche 210 dans laquelle sont générées les paires électron-trou qui sont à l'origine du signal de la structure forme la première zone 210 de la structure 1.

La première couche 200 présente une première et une seconde face 201, 202, la première face 201 étant la face par laquelle la première couche 200 est en contact avec le support 100. La première couche 200 est en contact par sa seconde face 202, qui est opposée à sa première face 201, avec une deuxième couche 300 semiconductrice. La deuxième couche 300 comporte une première face 301 longitudinale par laquelle elle est en contact avec la seconde face 202 de la première couche 100.

La deuxième couche 300 est une couche semiconductrice dans laquelle sont formées la deuxième et la troisième zone 310, 410. La deuxième couche, à l'exception de sa portion formant la troisième zone 410, est adaptée pour former une couche multiplicatrice de porteurs lors du fonctionnement de la structure 1. Pour obtenir une telle adaptation, la portion de la deuxième couche 300 qui forme la deuxième zone 310 comporte une concentration en porteurs majoritaires qui est au moins 10 fois inférieure à celle de la première zone 210 et préférentiellement 50 fois inférieure. La deuxième couche 300, en fonction des contraintes de fonctionnement de la structure 1 peut être du premier type de conductivité ou d'un deuxième type de conductivité qui est opposé au premier type de conductivité.

Selon une autre possibilité de l'invention, la portion de la deuxième couche 300 qui forme la deuxième zone 310 peut être du type intrinsèque ou du type non intentionnellement dopé.

Selon d'autres possibilités, qui ne seront pas développées dans ce document, la deuxième couche 310 peut comporter une première et une seconde sous-couche 303, 304 présentant respectivement le premier type de conductivité et un second type de conductivité opposé, ou du type intrinsèque et du premier type de conductivité, ou du premier type de conductivité et du type intrinsèque ou encore du type intrinsèque et du deuxième type de conductivité.

On entend par du « type intrinsèque » que la partie de la deuxième couche 300 qui forme la deuxième zone 310 comporte une concentration en porteurs d'un premier type qui est sensiblement identique à la concentration en porteurs d'un deuxième type qui est opposé au premier type de porteurs.

On entend par du « type non intentionnellement dopé » que la concentration en porteurs majoritaires dans la portion de la deuxième couche 300 qui forme la deuxième zone 310 est celle d'un matériau dans lequel il n'a pas été intentionnellement introduit d'éléments dopants, c'est-à-dire d'éléments adaptés pour fournir des porteurs. La concentration et le type de porteurs majoritaires dans une zone du type non intentionnellement dopé sont liés au procédé de formation de ladite zone.

La deuxième couche 300 comporte une première et une deuxième sous-couche 303, 304. La première et la deuxième sous-couche 303, 304 sont les sous-couches par lesquelles la deuxième couche 300 est en contact respectif avec la première couche 200 semiconductrice et la couche de passivation 620.

La première et la deuxième sous-couche 303, 304 comportent respectivement la première et la deuxième sous-partie 321, 322 de la deuxième zone 310.

La première et la deuxième sous-couche 303, 304 sont adaptées de manière à ce que la deuxième sous-partie 322 présente un taux moyen de multiplication de porteurs par micromètre supérieur à celui de la première sous-partie, le taux moyen de multiplication de porteurs par micromètre de la deuxième sous-partie étant préférentiellement supérieur à au moins 3 fois, 5 fois, voire 10 fois, à celui de la première sous-partie 321. A cet effet, la deuxième sous-couche 304 comporte une largeur de bande interdite inférieure à celle de la première sous-couche 303.

Les rapports de taux moyen de multiplication de porteurs par micromètre donnés ci-dessus s'entendent en fonctionnement de la structure 1. La structure 1 est considérée en fonctionnement lors de sa polarisation à une tension nominale de fonctionnement, telle que par exemple 12 V.

De même, pour une première et une deuxième sous-partie 321,322 présentant des épaisseurs du même ordre de grandeur, ou préférentiellement sensiblement identiques, un rapport des taux multiplication de porteurs entre lesdites première et deuxième sous-parties 321,322 est équivalent au rapport des taux moyen de porteurs par micromètre entre ces deux mêmes sous-parties 321,322. Ainsi, dans cette configuration des première et deuxième sous-parties, la deuxième sous-partie 322 présente un taux de multiplication de porteurs au moins supérieur à 3 fois, 5 fois, préférentiellement 10 fois, au taux moyen de multiplication de porteurs de la première sous-partie 321.

L'épaisseur de chacune de la première et de la deuxième sous-partie 321, 322 est préférentiellement supérieure à 200 nm.

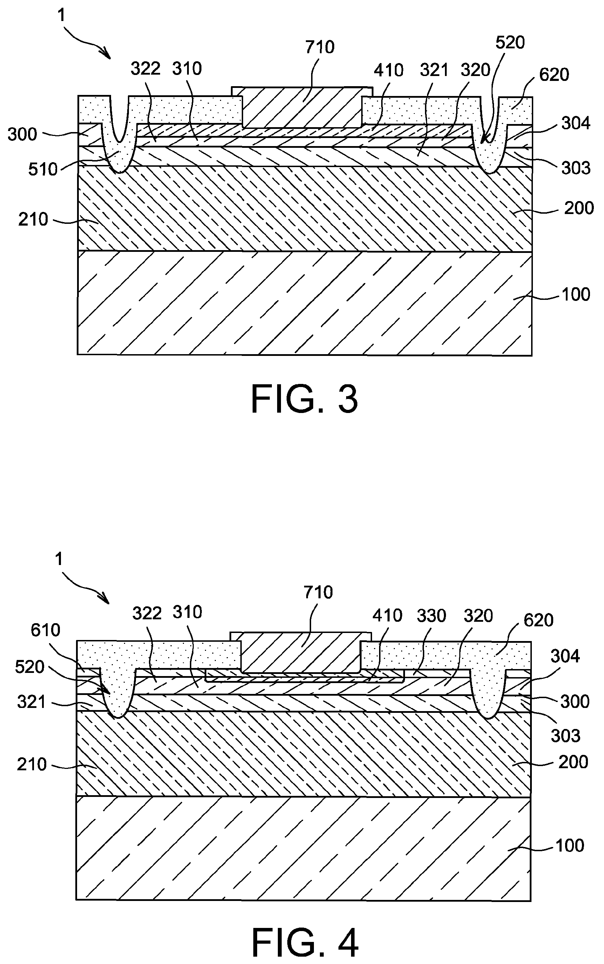

La figure 2 illustre ainsi graphiquement la variation du taux de multiplication de porteurs d'une zone de multiplication en tellurure de mercure-cadmium d'une structure de l'art antérieur en fonction à la fois de la longueur d'onde de coupure λ_{c} de ladite zone, qui correspond directement à sa largueur de bande interdite de cette même zone, et de la tension de polarisation de la structure. Cette figure est issue d'un article de J. Rothman et Al. publié dans la revue scientifique « Journal of Electronic Materials » n°42 p2928 en 2012. Pour une structure comportant une première et une deuxième sous-partie 321, 322 présentant chacune les caractéristiques identiques à celle d'une zone de multiplication de la figure 4 et pour une tension de polarisation de 12V appliquée à la structure, la chute de tension va se répartir de façon équivalente le long des deux sous-parties 321, 322. Ainsi, les taux de multiplication le long de telles première et deuxième sous-parties avec une telle tension de polarisation correspondant à ceux de zones de multiplication selon la figure 4 qui comportent la même longueur d'onde de coupure λ_{c} à la tension de polarisation de la structure divisée par deux, c'est-à-dire une tension de 6 V.

Ainsi, par exemple pour une première sous-partie 321 dont la longueur de coupure λ_{c} est de 2,5 µm, ce qui correspond à une largeur de bande interdite de 0,45 eV, et une deuxième sous-partie 322 dont la longueur d'onde de coupure λ_{c} est de 3,9 µm, ce qui correspond à une largeur de bande interdite de 0,32 eV, les taux de multiplication sont respectivement de 2 (voir le point 802 sur la figure 2) et de 20 (voir le point 801 sur la figure 2). On obtient donc des rapports de taux de multiplication de porteurs entre la première et la deuxième sous-partie 321, 322 et de taux moyens de multiplication de porteurs entre ces deux mêmes parties égaux à 10.

Afin d'obtenir ces conditions, dans l'application particulière, la première et la deuxième sous-couche 303, 304 sont toutes deux réalisées dans un tellurure de mercure-cadmium du type CdₓHg₁₋ₓTe avec des proportions x₁, x₂ de cadmium respectivement comprises entre 0,6 et 0,33, et entre 0,42 et 0,2. Les épaisseurs de la première et de la deuxième sous-couche 303, 304 sont respectivement comprises entre 0,5 et 1 µm et entre 0,5 et 2 µm. La première et la deuxième sous-couche présentent un second type de conductivité dont les porteurs majoritaires sont des électrons. Les concentrations en porteurs majoritaires de la première et de la seconde sous-couche sont sensiblement identiques et sont comprises entre 10¹⁴ et 10¹⁵ cm⁻³.

Selon cette possibilité de l'invention, la largeur de bande interdite de la deuxième sous-couche 304 peut être adaptée pour favoriser l'absorption du rayonnement électromagnétique dans une deuxième gamme de longueurs d'onde dont l'énergie est inférieure à la gamme de longueurs d'onde donnée. Avec une telle possibilité, la structure 1 permet, en fonctionnement la détection et la mesure d'un rayonnement dont la longueur d'onde est comprise dans la deuxième gamme de longueurs d'onde en complément de la mesure de rayonnements électromagnétiques à la longueur d'onde donnée.

Selon cette possibilité appliquée à l'application particulière la proportion x₂ en cadmium de la deuxième sous-couche 304 peut être comprise entre 0,32 et 0,2 pour fournir une deuxième gamme de longueurs d'onde comprenant le rayonnement thermique.

On entend ci-dessus par rayonnement thermique la gamme de longueurs d'onde des infrarouges comprise entre 3 et 10 µm.

Selon une alternative de l'invention non illustrée, la première et la deuxième couche 303, 304 sont séparées l'une de l'autre par une zone d'interface du premier type de conductivité dont la concentration en porteurs majoritaires est adaptée pour modifier la répartition du champ électrique dans la deuxième sous-partie afin que cette dernière présente un taux moyen de multiplication de porteurs par micromètre supérieur à celui de la première sous-partie, la deuxième sous-partie présentant un taux moyen de multiplication de porteurs par micromètre supérieur à au moins 3 fois et préférentiellement 5 fois, voire 10 fois, celui de la première sous-partie.. Selon cette alternative, la première et la deuxième sous-couche 303, 304 présentent des largeurs de bande interdite sensiblement identiques et sont du deuxième type de conductivité avec une concentration en porteurs majoritaires du même ordre de grandeur.

La cavité 520 est aménagée dans la deuxième couche 300 de manière à délimiter latéralement la deuxième zone 310. Ainsi la cavité 520 traverse la deuxième couche 300 sur toute son épaisseur. La cavité 520 forme un moyen de délimitation latérale de la deuxième zone 310.

La deuxième sous-couche 304 comporte également la troisième zone 410 semiconductrice.

La troisième zone 410 est du deuxième type de conductivité qui est opposé au premier type de conductivité. La troisième zone 410 comporte une concentration en porteurs majoritaires au moins 10 fois, et préférentiellement 50 fois, plus importante que celle de la deuxième zone 310.

La largeur de bande interdite de la troisième zone 410 est sensiblement identique à celle de la deuxième sous-partie 322 de la deuxième zone 310.

Dans l'application particulière, la troisième zone 410 présente le même type de conductivité que celui de la deuxième zone 310. La concentration en porteurs majoritaires est comprise entre 10¹⁶ et 10¹⁸ cm⁻³.

La deuxième couche 300 est en contact sur sa face qui est opposée à la première couche 200 avec la couche de passivation 620.

La couche de passivation 620 s'étend le long de la deuxième couche 300. La couche de passivation 620 est préférentiellement formée dans un matériau isolant, tel que par exemple l'oxyde de silicium.

La couche de passivation 620 présente une ouverture traversante en communication avec la partie de la deuxième couche 300 comportant la troisième zone 410.

Dans l'application particulière, la couche de passivation 620 est réalisée en sulfure de zinc ZnS.

Le contact électrique 710 est en contact avec la troisième zone 410 au travers de l'ouverture aménagée dans la couche de passivation 620.

Le contact électrique 710 est formé dans un matériau conducteur, généralement métallique, adapté pour former un contact ohmique avec la troisième zone 410 semiconductrice.

On peut enfin noter que la structure 1 comporte également, bien que cela ne soit pas illustré sur la figure 1, un deuxième moyen de polarisation, qui peut être un contact électrique traversant la couche de passivation 620 et la deuxième couche 300 semiconductrice pour être en contact électrique avec la première couche 200 semiconductrice. La première couche 200 semiconductrice présentant généralement une concentration en porteurs majoritaires suffisante pour la rendre conductrice, la structure 1 étant une structure parmi une pluralité, le deuxième moyen peut être un deuxième contact électrique collectif adapté pour polariser plusieurs des structures.

Une telle structure 1, lorsqu'elle est une structure selon l'application particulière, peut être formée par un procédé de fabrication comportant les étapes consistant à :
- fournir un support 100 et la première couche 200, celle-ci étant du premier type de conductivité et comportant une première et une seconde face 201, 202, la première couche comportant la première zone 210,
- former en contact avec la deuxième face 202 de la première couche 200 la deuxième couche 300, celle-ci étant du deuxième type de conductivité et comportant une première et une seconde face 301, 302, la deuxième couche 300 étant en contact avec la première couche 200 par sa première face 301 ; lors de cette étape, la composition de la couche 300 est variée de manière à former la première et la deuxième sous-couche 303, 304,
- former la couche de passivation 620 sur la face de la deuxième couche 300 qui est opposée à la première couche 200,
- implanter sélectivement avec des éléments dopants une portion de la deuxième sous-couche 304 de la deuxième couche 300 de manière à former ainsi la troisième zone 410,
- former dans la couche de passivation 620 une ouverture traversante en communication avec la troisième zone 410,
- former le contact électrique 710 au travers de l'ouverture de la couche de passivation 620 et en contact électrique avec la troisième zone 410,
- former le deuxième moyen de polarisation adapté pour polariser la première zone 210.

En fonctionnement, la structure 1 est fortement polarisée en inverse, c'est-à-dire que pour une première et une troisième zone 210, 410 présentant chacune un type de conduction dans lequel les porteurs majoritaires sont respectivement des trous et des électrons, la première zone 210 est fortement polarisée négativement vis-à-vis de la troisième zone 410. Ainsi, la jonction semiconductrice se trouvant à l'interface entre la première et la deuxième zone 210, 310, et la deuxième zone 310 présentant une faible concentration en porteurs majoritaires vis-à-vis de la première zone 210, la chute de potentiel se répartit principalement le long de la deuxième zone 310 semiconductrice.

Lorsqu'un photon d'un rayonnement électromagnétique dont la longueur d'onde est comprise dans la gamme de longueurs d'onde donnée pénètre dans la première zone 210, son absorption génère dans la première zone 210 une paire électron-trou. L'électron et le trou ainsi générés sont séparés l'un de l'autre par le champ électrique présent dans la structure avec l'électron qui transite vers la deuxième zone 310 semiconductrice.

Dans la deuxième zone 310, en raison du matériau qui la compose et du champ électrique qui y règne, l'électron va produire un nombre multiple d'ionisations par impact et donc former un courant de multiples électrons qui est ensuite collecté par la troisième zone 410.

Plus précisément, l'électron, en passant tout d'abord dans la première sous-partie 321 de la deuxième zone 310, génère un nombre réduit d'électron par ionisation par impact avec une faible réduction du rapport signal sur bruit. Le courant ainsi formé transite ensuite dans la deuxième sous-partie 322 dans laquelle il génère un nombre important de porteurs par ionisation par impact. Le courant est ainsi fortement augmenté sans réelle réduction du rapport signal sur bruit. Le courant après multiplication dans la deuxième sous-partie 322 de la deuxième zone 310 est alors collecté par la troisième zone 410.

La figure 3 illustre une structure selon un deuxième mode de réalisation dans lequel la troisième zone 410 s'étend sur la totalité de la largeur de la deuxième zone 310. Une structure 1 selon ce deuxième mode de réalisation se différencie d'une structure 1 selon le premier mode de réalisation en ce que la troisième zone 410 s'étend sur la totalité de la largeur de la deuxième zone 310 et en ce que la troisième zone 410 fait interface entre la couche de passivation 620 et la deuxième zone 310.

La troisième zone 410 est aménagée dans une portion de la deuxième sous-couche 304 de la deuxième couche 300.

Un procédé de fabrication d'une structure 1 selon ce deuxième mode de réalisation se différencie d'un procédé de fabrication d'une structure 1 selon le premier mode de réalisation en ce que lors de l'étape d'implantation d'une portion de la deuxième sous-couche 304 de la deuxième couche 300, l'implantation est réalisée sur la totalité de la largeur de la deuxième zone 310 sur une partie de la hauteur de la deuxième sous-couche 304 de la deuxième couche 300.

Une structure 1 selon ce deuxième mode de réalisation fonctionne selon un principe sensiblement identique à celui d'une structure 1 selon le premier mode de réalisation.

La figure 4 illustre une structure 1 selon un troisième mode de réalisation dans lequel la structure 1 comporte une couche d'adaptation 610. Une structure 1 selon ce troisième mode de réalisation se différencie d'une structure 1 selon le premier mode de réalisation en ce que la deuxième zone 310 est aménagée à la fois dans la deuxième couche 300 et dans la couche d'adaptation 610. La première et la deuxième sous-partie 321, 322 forme une partie 320, dite majeure partie, de la deuxième zone 310, qui est comprise dans la deuxième couche 300.

Dans ce troisième mode de réalisation, la deuxième couche 300 semiconductrice comporte une seconde face 302 qui est opposée à la première face. La deuxième couche 300 est contact par sa deuxième face 302 avec la couche d'adaptation 610.

La couche d'adaptation 610 est une troisième couche semiconductrice qui est adaptée pour former une bonne interface entre la deuxième couche 300 semiconductrice et la couche de passivation 620. A cet effet, la couche d'adaptation 610 présente une largeur de bande interdite intermédiaire entre celle de la majeure partie 320 de la deuxième zone 310 et la largeur de bande interdite de la couche de passivation 620.

La couche d'adaptation 610 est du deuxième type de conductivité. La couche d'adaptation 610 comporte, à l'exclusion de sa portion formant la troisième zone 410, une concentration en porteurs majoritaires qui est du même ordre de grandeur que celle de la majeure partie 320 de la deuxième zone 310 et préférentiellement sensiblement égale à celle de la majeure partie 320 de la deuxième zone 310. Ainsi la couche d'adaptation 610 comporte une partie 330 de la deuxième zone 310, dite mineur partie, par laquelle la deuxième zone 310 est en contact avec la couche de passivation 610.

La deuxième zone 310 est ainsi formée essentiellement d'une partie 320, dite majeure, située dans la deuxième couche 300. Elle peut aussi comporter une partie 330, dite mineure, située dans la couche d'adaptation 610.

Dans l'application particulière, la couche d'adaptation 610 est formée dans un tellurure de mercure-cadmium CdₓHg₁₋ₓTe dont la proportion en cadmium x est comprise entre 0,7 et 0,4. Dans cette même application particulière, la couche d'adaptation 610 est du même type de conductivité que celui de la deuxième zone 310 et est donc un type de conductivité pour lequel les porteurs majoritaires sont des électrons. La concentration en porteurs majoritaires est sensiblement égale à celle de la deuxième zone 310 et est donc comprise entre 10¹⁴ et 10¹⁵ cm⁻³.

La couche d'adaptation 610 comporte une part de la troisième zone 410. La troisième zone 410 est partiellement formée dans la deuxième couche 300, en contact avec la deuxième zone 310, le reste de la troisième zone 410 étant compris dans la couche d'adaptation 610.

Selon une alternative de cette possibilité, la couche d'adaptation 610 peut comporter une composition telle que la couche d'adaptation présente une largeur de bande interdite augmentant graduellement en direction de la couche de passivation 620. Une telle possibilité est particulièrement avantageuse en ce qu'elle permet d'éviter de former des défauts entre la deuxième couche 300 et la couche de passivation 620.

La cavité 520, selon ce troisième mode de réalisation, traverse également la couche d'adaptation 610.

## Revendications

1. Structure (1) semiconductrice de type photodiode à avalanche destinée à recevoir un rayonnement électromagnétique dans une gamme de longueurs d'onde donnée et comportant :
- une première zone (210) semiconductrice, dite d'absorption, d'un premier type de conductivité présentant une première face destinée à recevoir le rayonnement électromagnétique et une seconde face opposée à la première face, le matériau semiconducteur dans lequel est formée ladite première zone (210) présentant une largeur de bande interdite adaptée pour favoriser l'absorption du rayonnement électromagnétique,
- une deuxième zone (310) semiconductrice, dite de multiplication, en contact avec la seconde face de la première zone (210), la deuxième zone (310) présentant une concentration en porteurs majoritaires inférieure à celle de la première zone (210), ladite deuxième zone (310) étant adaptée pour fournir une multiplication de porteurs par ionisation par impact qui est prépondérante pour un type de porteurs,
- une troisième zone (410) semiconductrice, dite de collecte, en contact avec la deuxième zone (310) semiconductrice, ladite troisième zone (410) étant d'un deuxième type de conductivité opposé au premier type de conductivité et présentant une concentration en porteurs majoritaires supérieure que celle de la deuxième zone (310) semiconductrice,
la structure étant **caractérisée en ce que** la deuxième zone (310) comporte au moins deux sous-parties (321, 322), une première sous-partie (321) par laquelle la deuxième zone (310) est en contact avec la première zone (210) et une deuxième sous-partie (322) reliant la première sous-partie (321) à la troisième zone (410), la deuxième sous-partie (322) étant adaptée pour présenter un taux moyen de multiplication de porteurs par micromètre supérieur au taux moyen de multiplication de porteurs de la première sous-partie (321), et préférentiellement supérieur à 3 fois, 5 fois, 25 voire 10 fois le taux moyen de multiplication de porteurs par micromètre de la première sous-partie (321),
dans laquelle la deuxième sous-partie (322) est réalisée dans un matériau semiconducteur présentant une largeur de bande interdite inférieure à celle du matériau semiconducteur dans lequel est formée la première sous-partie (321) de manière à présenter le taux moyen de multiplication de porteurs par micromètre supérieur à celui de la première sous-partie (321),
dans laquelle la première et la deuxième sous-partie (321, 322) sont réalisées dans des tellurures de mercure-cadmium du type CdₓHg₁₋ₓTe avec des proportions x en cadmium différentes l'une de l'autre, et
dans laquelle la première et la deuxième sous-partie (321, 322) de la première zone sont toutes deux des couches dont l'épaisseur minimum est supérieure à 200 nm.

2. Structure (1) selon la revendication 1, dans laquelle les première, deuxième et troisième zones (210, 310, 410) sont toutes trois réalisées dans des tellurures de mercure-cadmium du type CdₓHg₁₋ₓTe avec des proportions x en cadmium différentes les une des autres, le premier type de conductivité étant un type de conductivité dans lequel les porteurs majoritaires sont des trous, assurant de cette manière que l'ionisation par impact dans la deuxième zone est prépondérante pour les électrons.

3. Structure (1) selon l'une quelconque des revendications précédentes, dans laquelle la première sous-partie (321) présente un gain de multiplication de porteurs compris entre 2 et 10, la deuxième sous-partie (322) présentant un gain de multiplication de porteurs compris entre 10 et 500.

4. Structure (1) selon l'une quelconque des revendications précédentes, au moins la deuxième sous-partie (322) de la deuxième zone est du deuxième type de conductivité.

5. Structure (1) selon l'une quelconque des revendications précédentes dans laquelle, la structure (1) est en outre destinée à recevoir un rayonnement électromagnétique dans une deuxième gamme de longueurs d'onde d'énergies inférieures à celles de la première gamme de longueurs d'onde, la deuxième sous-partie (322) de la deuxième zone (310) comportant une largeur de bande interdite inférieure à celle de la première zone (210) semiconductrice et à celle de la première sous-partie (321) et qui est adaptée pour favoriser l'absorption du rayonnement électromagnétique dans la deuxième gamme de longueurs d'onde.

6. Procédé de fabrication d'une structure (1) semiconductrice selon l'une quelconque des revendications précédentes comportant les étapes consistant à :
- fournir une première zone (210) semiconductrice d'un premier type de conductivité présentant une première face destinée à recevoir le rayonnement électromagnétique et une seconde face opposée à la première face, le matériau semiconducteur dans lequel est formée ladite première zone (210) présentant une largeur de bande interdite adaptée pour favoriser l'absorption du rayonnement électromagnétique,
- former une deuxième zone (310) semiconductrice en contact avec la seconde face de la première zone (210), la deuxième zone (310) présentant une concentration en porteurs majoritaires inférieure à celle de la première zone (210), ladite deuxième zone (310) étant adaptée pour fournir une multiplication de porteurs par ionisation par impact qui est prépondérante pour un type de porteurs, la deuxième zone (310) comportant au moins deux sous-parties (321, 322), une première sous-partie (321) par laquelle la deuxième zone (310) est en contact avec la première zone (210) et une deuxième sous-partie (322) destinée à relier la première sous-partie (321) à la troisième zone (410), la deuxième sous-partie (322) étant adaptée pour présenter un taux moyen de multiplication de porteurs par micromètre plus important que le taux moyen de multiplication de porteurs par micromètre de la première sous-partie (321), et préférentiellement supérieur à 3 fois, 5 fois, voire 10 fois le taux moyen de multiplication de porteurs par micromètre de la première sous-partie (321), la deuxième sous-partie (322) étant réalisée dans un matériau semiconducteur présentant une largeur de bande interdite inférieure à celle du matériau semiconducteur dans lequel est formée la première sous-partie (321) de manière à présenter le taux moyen de multiplication de porteurs par micromètre supérieur à celui de la première sous-partie (321), la première et la deuxième sous-partie (321, 322) étant réalisées dans des tellurures de mercure-cadmium du type CdₓHg₁₋ₓTe avec des proportions x en cadmium différentes l'une de l'autre, la première et la deuxième sous-partie (321, 322) de la première zone étant toutes deux des couches dont l'épaisseur minimum est supérieure à 200 nm.
- former une troisième zone semiconductrice (410) en contact avec la deuxième zone (310) semiconductrice, ladite troisième zone (410) étant d'un deuxième type de conductivité opposé au premier type de conductivité et présentant une concentration en porteurs majoritaires supérieure à celle de la deuxième zone (310) semiconductrice.

## Patentansprüche

1. Halbleiterstruktur (1) vom Typ Avalanche-Photodiode, die dazu ausgelegt ist, elektromagnetische Strahlung in einem gegebenen Wellenlängenbereich zu empfangen, und die umfasst:
- eine erste sogenannte Absorptions-Halbleiterzone (210) eines ersten Leitfähigkeitstyps, die eine erste Fläche aufweist, welche dazu ausgelegt ist, die elektromagnetische Strahlung zu empfangen, und eine zweite Fläche, die der ersten Fläche entgegengesetzt ist, wobei das Halbleitermaterial, in dem die erste Zone (210) gebildet ist, eine Breite des verbotenen Bands aufweist, die dazu ausgelegt ist, die Absorption von elektromagnetischer Strahlung zu begünstigen,
- eine zweite sogenannte Multiplikations-Halbleiterzone (310) in Kontakt mit der zweiten Fläche der ersten Zone (210), wobei die zweite Zone (310) eine Konzentration von Majoritätsladungsträgern aufweist, die kleiner ist als jene der ersten Zone (210), wobei die zweite Zone (310) dazu ausgelegt ist, eine Multiplikation von Ladungsträgern durch Stoßionisation zu liefern, die für einen Typ von Ladungsträgern überwiegt,
- eine dritte sogenannte Sammel-Halbleiterzone (410) in Kontakt mit der zweiten Halbleiterzone (310), wobei die dritte Zone (410) von einem zweiten Leitfähigkeitstyp ist, der dem ersten Leitfähigkeitstyp entgegengesetzt ist, und eine Konzentration von Majoritätsladungsträgern aufweist, die größer ist als jene der zweiten Halbleiterzone (310),
wobei die Struktur **dadurch gekennzeichnet ist, dass** die zweite Zone (310) wenigstens zwei Teilbereiche (321, 322) umfasst, einen ersten Teilbereich (321), durch den die zweite Zone (310) in Kontakt mit der ersten Zone (210) ist, und einen zweiten Teilbereich (322), der den ersten Teilbereich (321) mit der dritten Zone (410) verbindet, wobei der zweite Teilbereich (322) dazu ausgelegt ist, eine mittlere Multiplikationsrate von Ladungsträgern pro Mikrometer aufzuweisen, die größer ist als die mittlere Multiplikationsrate von Ladungsträgern des ersten Teilbereichs (321), und vorzugsweise größer als 3 mal, 5 mal oder auch 10 mal die mittlere Multiplikationsrate von Ladungsträgern pro Mikrometer des ersten Teilbereichs (321),
wobei der zweite Teilbereich (322) in einem Halbleitermaterial realisiert ist, das eine Breite des verbotenen Bands aufweist, die kleiner ist als jene des Halbleitermaterials, in dem der erste Teilbereich (321) gebildet ist, derart, dass er die mittlere Multiplikationsrate von Ladungsträgern pro Mikrometer aufweist, die größer ist als jene des ersten Teilbereichs (321),
wobei der erste und der zweite Teilbereich (321, 322) aus Telluriden von Quecksilber-Cadmium vom Typ CdₓHg₁₋ₓTe realisiert sind, mit Anteilen x von Cadmium, die voneinander verschieden sind, und
wobei der erste und der zweite Teilbereich (321, 322) der ersten Zone jeweils Schichten sind, deren minimale Dicke größer als 200 nm ist.

2. Struktur (1) nach Anspruch 1, wobei die erste, die zweite und die dritte Zone (210, 310, 410) jeweils aus Telluriden von Quecksilber-Cadmium vom Typ CdₓHg₁₋ₓTe realisiert sind, mit Anteilen x von Cadmium, die voneinander verschieden sind, wobei der erste Leitfähigkeitstyp ein Leitfähigkeitstyp ist, bei dem die Majoritätsladungsträger Löcher sind, so dass auf diese Weise gewährleistet wird, dass die Stoßionisation in der zweiten Zone für die Elektronen überwiegt.

3. Struktur (1) nach einem der vorhergehenden Ansprüche, wobei der erste Teilbereich (321) eine Multiplikationsverstärkung von Ladungsträgern aufweist, die zwischen 2 und 10 enthalten ist, wobei der zweite Teilbereich (322) eine Multiplikationsverstärkung von Ladungsträgern aufweist, die zwischen 10 und 500 enthalten ist.

4. Struktur (1) nach einem der vorhergehenden Ansprüche, wobei wenigstens der zweite Teilbereich (322) der zweiten Zone vom zweiten Leitfähigkeitstyp ist.

5. Struktur (1) nach einem der vorhergehenden Ansprüche, wobei die Struktur (1) ferner dazu ausgelegt ist, eine elektromagnetische Strahlung in einem zweiten Wellenlängenbereich von Energien zu empfangen, die kleiner sind als jene des ersten Wellenlängenbereichs, wobei der zweite Teilbereich (322) der zweiten Zone (310) eine Breite des verbotenen Bands umfasst, die kleiner ist als jene der ersten Halbleiterzone (210) und als jene des ersten Teilbereichs (321), und dazu ausgelegt ist, die Absorption von elektromagnetischer Strahlung in dem zweiten Wellenlängenbereich zu begünstigen.

6. Verfahren zur Herstellung einer Halbleiterstruktur (1) nach einem der vorhergehenden Ansprüche, umfassend die folgenden Schritte:
- Bereitstellen einer ersten Halbleiterzone (210) eines ersten Leitfähigkeitstyps, die eine erste Fläche aufweist, welche dazu ausgelegt ist, die elektromagnetische Strahlung zu empfangen, und eine zweite Fläche, die der ersten Fläche entgegengesetzt ist, wobei das Halbleitermaterial, in dem die erste Zone (210) gebildet ist, eine Breite des verbotenen Bands aufweist, die dazu ausgelegt ist, die Absorption der elektromagnetischen Strahlung zu begünstigen,
- Bilden einer zweiten Halbleiterzone (310) in Kontakt mit der zweiten Fläche der ersten Zone (210), wobei die zweite Zone (310) eine Konzentration von Majoritätsladungsträgern aufweist, die kleiner ist als jene der ersten Zone (210), wobei die zweite Zone (310) dazu ausgelegt ist, eine Multiplikation von Ladungsträgern durch Stoßionisation bereitzustellen, die für einen Typ von Ladungsträgern überwiegt, wobei die zweite Zone (310) wenigstens zwei Teilbereiche (321, 322) umfasst, einen ersten Teilbereich (321), durch den die zweite Zone (310) in Kontakt mit der ersten Zone (210) ist, und einen zweiten Teilbereich (322), der dazu ausgelegt ist, den ersten Teilbereich (321) mit der dritten Zone (410) zu verbinden, wobei der zweite Teilbereich (322) dazu ausgelegt ist, eine mittlere Multiplikationsrate von Ladungsträgern pro Mikrometer aufzuweisen, die größer ist als die mittlere Multiplikationsrate von Ladungsträgern pro Mikrometer des ersten Teilbereichs (321), und vorzugsweise größer als 3 mal, 5 mal, oder auch 10 mal die mittlere Multiplikationsrate von Ladungsträgern pro Mikrometer des ersten Teilbereichs (321), wobei der zweite Teilbereich (322) in einem Halbleitermaterial realisiert ist, das eine Breite des verbotenen Bands aufweist, die kleiner ist als jene des Halbleitermaterials, in dem der erste Teilbereich (321) gebildet ist, derart, dass er die mittlere Multiplikationsrate von Ladungsträgern pro Mikrometer aufweist, die größer ist als jene des ersten Teilbereichs (321), wobei der erste und der zweite Teilbereich (321, 322) aus Telluriden von Quecksilber-Cadmium vom Typ CdₓHg₁₋ₓTe realisiert sind, mit Anteilen x von Cadmium, die voneinander verschieden sind, wobei der erste und der zweite Teilbereich (321, 322) der ersten Zone jeweils Schichten sind, deren minimale Dicke größer als 200 nm ist.
- Bilden einer dritten Halbleiterzone (410) in Kontakt mit der zweiten Halbleiterzone (310), wobei die dritte Zone (410) von einem zweiten Leitfähigkeitstyp entgegengesetzt zum ersten Leitfähigkeitstyp ist und eine Konzentration von Majoritätsladungsträgern aufweist, die größer ist als jene der zweiten Halbleiterzone (310).

## Claims

1. Avalanche photodiode semiconductor structure (1) for receiving electromagnetic radiation in a given wavelength range and comprising:
- a first so-called absorption semiconductor area (210), of a first type of conductivity having a first face for receiving the electromagnetic radiation and a second face opposite the first face, the semiconductor material in which is formed said first area (210) having an energy band gap suitable for allowing the absorption of the electromagnetic radiation,
- a second so-called multiplication semiconductor area (310), in contact with the second face of the first area (210), the second area (310) having a majority carrier concentration that is less than that of the first area (210), said second area (310) being suitable for providing a multiplication of carriers by impact ionisation that is preponderant for one type of carrier,
- a third so-called collection semiconductor area (410), in contact with the second semiconductor area 310), said third area (410) being of a second type of conductivity opposite the first type of conductivity and having a majority carrier concentration that is greater than that of the second semiconductor area (310),
the structure being **characterised in that** the second area (310) comprises at least two subparts (321, 322), a first subpart (321) through which the second area (310) is in contact with the first area (210) and a second subpart (322) connecting the first subpart (321) to the third area (410), the second subpart (322) being suitable for having a mean carrier multiplication rate by micrometre that is greater than the mean carrier multiplication rate of the first subpart (321), and preferentially greater than 3 times, 5 times, even 10 times the mean carrier multiplication rate by micrometre of the first subpart (321),
wherein the second subpart (322) is made from a semiconductor material having an energy band gap that is less than that of the semiconductor material in which is formed the first subpart (321) in such a way as to have the mean carrier multiplication rate by micrometre greater than that of the first subpart (321),
wherein the first and the second subpart (321, 322) are made from mercury-cadmium tellurides of the CdₓHg₁₋ₓTe type with proportions x in cadmium that are different from one another, and
wherein the first and the second subpart (321, 322) of the first area are both layers of which the minimum thickness is greater than 200 nm.

2. Structure (1) according to claim 1, wherein the first, second and third areas (210, 310, 410) are all three made from mercury-cadmium tellurides of the CdxHg₁₋ₓTe type with proportions x in cadmium that are different from one another, with the first type of conductivity being a type of conductivity wherein the majority carriers are holes, providing in this way that the impact ionisation in the second area is preponderant for the electrons.

3. Structure (1) as claimed in any preceding claim, wherein the first subpart (321) has a gain in multiplication of carriers between 2 and 10, the second subpart (322) having a gain in multiplication of carriers between 10 and 500.

4. Structure (1) as claimed in any preceding claim, at least the second subpart (322) of the second area is of the second type of conductivity.

5. Structure (1) as claimed in any preceding claim wherein, the structure (1) is furthermore for receiving electromagnetic radiation in a second wavelength range of energies less than those of the first wavelength range, the second subpart (322) of the second area (310) comprising an energy band gap less than that of the first semiconductor area (210) and that of the first subpart (321) and which is suitable for allowing the absorption of the electromagnetic radiation in the second wavelength range.

6. Method for manufacturing a semiconductor structure (1) as claimed in any preceding claim comprising the steps consisting in:
- providing a first semiconductor area (210) of a first type of conductivity having a first face for receiving the electromagnetic radiation and a second face opposite the first face, the semiconductor material in which is formed said first area (210) having an energy band gap suitable for allowing the absorption of the electromagnetic radiation,
- forming a second semiconductor area (310) in contact with the second face of the first area (210), the second area (310) having a majority carrier concentration that is less than that of the first area (210), said second area (310) being suitable for providing a multiplication of carriers by impact ionisation that is preponderant for one type of carrier, the second area (310) comprising at least two subparts (321, 322), a first subpart (321) through which the second area (310) is in contact with the first area (210) and a second subpart (322) for connecting the first subpart (321) to the third area (410), the second subpart (322) being suitable for having a mean carrier multiplication rate by micrometre that is greater than the mean carrier multiplication rate by micrometre of the first subpart (321), and preferentially greater than 3 times, 5 times, even 10 times the mean carrier multiplication rate by micrometre of the first subpart (321), the second subpart (322) being made from a semiconductor material having an energy band gap that is less than that of the semiconductor material in which is formed the first subpart (321) in such a way as to have the mean carrier multiplication rate by micrometre greater than that of the first subpart (321), the first and the second subpart (321, 322) being made from mercury-cadmium tellurides of the CdₓHg₁₋ₓTe type with proportions x in cadmium that are different from one another, the first and the second subpart (321, 322) of the first area being both layers of which the minimum thickness is greater than 200 nm.
- forming a third semiconductor area (410) in contact with the second semiconductor area (310), said third area (410) being of a second type of conductivity opposite the first type of conductivity and having a majority carrier concentration in that is greater than that of the second semiconductor area (310).
